# EUROPÄISCHE PATENTANMELDUNG

(11) **EP 2 053 744 A2**
(43) Veröffentlichungstag der Anmeldung: **29.04.2009**
(21) Anmeldenummer: 08015579.9
(22) Anmeldetag: 04.09.2008
(51) Int. Cl.: H03K 17/955, E05B 65/00

(54) **Kapazitive Sensorik**

(30) Priorität: 27.10.2007 DE 102007051493
(71) Anmelder: RAFI GmbH & Co. KG, 88276 Berg (DE)
(72) Erfinder: Riedesser, Markus, D-88364 Wolfegg/Rötenbach (DE)
(74) Vertreter: Engelhardt, Volker

(57) **Zusammenfassung**

Mittels eines kapazitiven Messsensors (11) zur Erkennung der Annäherung eines Objektes (9) in Richtung des Messsensors (11), durch den ein kapazitives Messfeld (12) generierbar und durch den das Eindringen des Objektes (9) in das Messfeld (12) feststellbar ist, soll die charakteristische Annäherung bzw. die Bewegung des Objektes (9) an ein beliebiges Bauteil, wie beispielsweise Gebäude, Fahrzeugtür, Maschine oder Türrahmen ermittelbar sein. Des Weiteren soll der Abfragezeitpunkt, ob der zugangsberechtigte Benutzer die Entriegelung bzw. den Verschluss beispielsweise der Fahrzeugtüren wünscht, zu einem frühen Zeitpunkt stattfinden, der unmittelbar zeitlich vor dem Betätigen des Griffes (1) liegt.

Dies wird dadurch erzielt, dass mehrere der Messsensoren (11) in einem Bauteil (1') integriert sind, dass durch die Messsensoren (11) jeweils eines der Messfelder (12) erzeugbar ist, die in eine vorgegebene Richtung weisen und die elektrisch voneinander getrennt sind, und dass durch die Veränderung der Messfelder (12) elektrische Signale erzeugbar sind, durch die die charakteristische Annäherung des sich auf die Messsensoren (11) zu bewegenden Objektes (9) bestimmbar ist.

## Beschreibung

Die Erfindung bezieht sich auf eine kapazitive Sensorik und einen Griff, in den die Sensorik eingebaut ist, nach den Oberbegriffen der Patentansprüche 1 und 6.

Aus der US PS 5,442,347 ist der Aufbau eines kapazitiven Sensors zur Messung der Annäherung eines Objektes zu entnehmen. Durch den Sensor wird dabei ein kapazitives Messfeld erzeugt, dessen kapazitiver Wert durch das Eindringen des Objektes verändert wird und damit als elektrisches Signal erkennbar und auswertbar ist.

Solche Sensoren werden bereits in Griffen, die an Fahrzeugen vorgesehen sind, zum Aktivieren eines elektrischen betriebenen Abfragesystems eingesetzt. Eine schlüssellose Betätigungs- und/oder Schließeinrichtung kann beispielsweise der EP 1 235 190 A1 entnommen werden. Dabei trägt der berechtigte Benutzer einen elektrischen Schlüssel mit einer Zugangskennung an seinem Körper, der permanent oder durch Aktivieren eines Signals die Schlüsselkennung ausstrahlt, die von einer oder mehreren im Fahrzeug integrierten Empfangsantennen aufgefangen und an eine mit dem Steuergerät verbundene Auswerteeinheit weitergegeben wird. Durch die Auswerteeinheit wird festgestellt, ob die von dem Schlüssel ausgesandte Schlüsselkennung mit einem in der Auswerteeinheit gespeicherten Kannwert übereinstimmt. Ist dies der Fall, werden durch das Steuergerät die Schlösser an den einzelnen Fahrzeugtüren geöffnet und der Benutzer kann durch Betätigen des Griffes die Fahrzeugtür öffnen.

Als weitere Vereinfachung zur Betätigung der jeweiligen Tür ist diesem Stand der Technik zu entnehmen, dass die Türen automatisch geöffnet werden, wenn dies vom Benutzer gewünscht ist. Aus diesem Grund ist ein Sensor in den Griff eingebaut, der ein Messfeld, das in Richtung der Tür ausgerichtet ist, abstrahlt. Sobald daher der Benutzer seine Hand zwischen dem Griff und der Fahrzeugtür einschiebt, verändert sich das Messfeld. Diese Messfeldveränderung wird von dem Sensor ermittelt und an das Steuergerät weitergeleitet, wodurch das jeweilige Schloss dieser Tür geöffnet wird. Weiterhin kann vorgesehen sein, dass der Tür eine elektrisch, hydraulisch oder pneumatisch betriebene Öffnungs- bzw. Schliesseinrichtung zugeordnet ist, durch die die Tür selbsttätig geöffnet oder geschlossen werden kann.

Um den Energieverbrauch zur Überwachung, ob der Benutzer mit der Zugangskennung das Fahrzeug öffnen oder abschließen möchte, zu reduzieren, werden die elektrischen Geräte vollständig abgeschaltet und erst, wenn der Benutzer seine Hand zwischen dem Griff und der Fahrzeugtür eingeschoben hat, wird das vom Sensor aufgefangene Messsignal an die Auswerte- und Steuereinrichtung weitergegeben, wodurch diese aktiviert sind. Mit Aktivierung der Auswerteeinheit erfolgt die Abfrage, ob der an das Fahrzeug herangetretene Benutzer tatsächlich die entsprechende Zugangsberechtigung für das Fahrzeug in Form eines elektronischen Schlüssels besitzt.

Als nachteilig bei diesem Stand der Technik hat sich herausgestellt, dass erst mit Aktivierung des Steuergerätes und der Auswerteeinheit, also wenn die Hand des Benutzers zwischen dem Griff und der Fahrzeugtür eintaucht, die Abfrage der Zugangsberechtigung erfolgt. Dies führt jedoch dazu, dass die Hand des Benutzers bereits den Griff umschließt oder berührt und die Fahrzeugtür betätigt werden soll. Aufgrund der möglicherweise zeitverzögerten Abfrage der Zugangsberechtigung ist das Schloss der Fahrzeugtür jedoch von dem Steuergerät noch nicht freigegeben, so dass die Fahrzeugtür nicht aufgeschwenkt werden kann.

Des Weiteren hat sich als nachteilig gezeigt, dass oftmals durch Umwelteinflüsse, beispielsweise Regentropfen oder Blätter, die zwischen den Griff und die Fahrzeugtür gelangen, eine Änderung des Messfeldes eintreten, so das unbeabsichtigt die Steuergeräte bzw. die Auswerteeinheit im Fahrzeug aktiviert werden, obwohl der zugangsberechtigte Benutzer die Entriegelung des Fahrzeuges nicht wünscht. Derartige Aktivierungen der elektrischen Baueinheiten im Fahrzeug benötigen Energie, die durch die Fahrzeugbatterie zur Verfügung gestellt wird. Durch mehrfaches Aktivieren der Bauteile wird daher die Fahrzeugbatterie entladen und kann möglicherweise für den Startvorgang des Fahrzeuges nicht mehr genügend Strom zur Verfügung stellen.

Es ist daher Aufgabe der Erfindung, eine Sensorik der eingangs genannten Gattung bereitzustellen, durch die die charakteristische Annäherung bzw. die Bewegung eines Objektes an ein beliebiges Bauteil, wie beispielsweise Gebäude, Fahrzeugtür, Maschine oder Türrahmen feststellen zu können. Des Weiteren liegt der Erfindung die Aufgabe zugrunde, einen Griff der der eingangs genannten Gattung derart weiterzubilden, dass mit diesem der Abfragezeitpunkt, ob der zugangsberechtigte Benutzer die Entriegelung bzw. den Verschluss der Fahrzeugtüren wünscht, der zu einem Zeitpunkt stattfindet, der unmittelbar zeitlich vor dem Betätigen des Griffes liegt und durch den die Aktivierung der im Fahrzeug integrierten elektrischen Bauteile zur Überprüfung der Zugangsberechtigung für das Fahrzeug ausschließlich in Abhängigkeit von einem für die Annäherung an den Griff üblichen Bewegungsablauf des Benutzers erfolgt.

Diese Aufgaben werden erfindungsgemäß durch die Merkmale im kennzeichnenden Teil der Patentansprüche 1 und 6 gelöst.

Weitere vorteilhafte Weiterbildungen der Erfindung ergeben sich aus den Unteransprüchen.

Dadurch, dass durch die kapazitive Sensorik ein Messfeld mit einem bestimmten kapazitiven Wert erzeugt wird, der durch ein sich annäherndes Objekt veränderbar und durch den Sensor messbar ist, kann die charakteristische Annäherung des Objektes an den Sensor erfasst werden. Die charakteristischen Annäherungswerte des Objektes sind im Wesentlichen dessen geometrische Abmessungen, dessen Annäherungsgeschwindigkeit sowie dessen Annäherungsrichtung. Durch die Verwendung von mehreren benachbart zueinander angeordneten Sensoren in einem Bauteil, beispielsweise einem Griff einer Fahrzeugtür, einem Türrahmen in dem Bedienfeld einer Maschine oder der Außen- oder Innenfassade eines Gebäudes kann daher jedes beliebig sich an die Sensoren annähernde Objekt erfasst werden. Durch die technischen Maßnahmen können unbeabsichtigt sich annähernde Objekte von denjenigen Objekten unterschieden werden, durch die ein bestimmter Schalt- oder Abfragezyklus in Gang gesetzt werden soll. Durch die sich annähernden unbeabsichtigten Objekte wird der Schalt- oder Abfragezyklus daher nicht in Gang gesetzt, denn diese werden durch die ermittelten sich veränderten kapazitiven Werte des jeweiligen Messfeldes erkannt und daher ausgefiltert. Ausschließlich die Objekte, die in einem vorgegebenen Raster liegen, setzten daher den Abfrage- oder Schaltzyklus in Gang.

Insbesondere, wenn zwei benachbarte kapazitive Sensoren jeweils ein Messfeld generieren, die senkrecht zueinander stehen, können die Bewegungsrichtungen von sich den Sensoren annähernden Objekten erfasst und ermittelt werden.

Es ist besonders vorteilhaft, wenn der das Messfeld erzeugende Messsensor im oberen und vorderen Bereich des Griffes untergebracht ist, um ein von der Fahrzeugtür abstehendes räumliches Messfeld zu generieren. Sobald nämlich die Hand des Benutzers in Richtung des Griffes bewegt wird, verändert sich das Messfeld in Abhängigkeit von dem Abstand der Hand des Benutzers von dem Griff. Aufgrund der derart gewonnenen Information, die von der charakteristischen Bewegungsannäherung, wie Geschwindigkeit, Größe des Objektes und Bewegungsrichtung geprägt sind, kann die Auswerteeinheit feststellen, ob es sich tatsächlich um die Hand eines Benutzers handelt oder ob die Veränderung des Messfeld aufgrund eines vorbeifahrenden Gegenstandes, beispielsweise eines Fahrrades, hervorgerufen wurde. Die derart programmierte und eingerichtete Auswerteeinheit überprüft demnach zunächst, ob überhaupt die Hand eines Benutzers in Richtung des Türgriffes bewegt wird, und wenn dies der Fall ist, wird das Steuergerät und die Abfrage der Schlüsselkennung gestartet. Folglich ist insbesondere die Aktivierung zur Abfrage der Schlüsselkennung zeitlich dem Eintauchen der Benutzerhand zwischen Griff und Fahrzeugtür vorangestellt.

Die Veränderung des Messfeldes erfolgt unabhängig von der Beschaffenheit der Hand, denn aufgrund von vorab ermittelten und hinterlegten Messdaten können vorgegebene Bereiche erfasst werden, in denen jede Handgröße angesiedelt ist.

In der Zeichnung ist ein erfindungsgemäßes Ausführungsbeispiel dargestellt, das nachfolgend näher erläutert wird. Im Einzelnen zeigt:
- Figur 1: einen an einer Tür angebrachten Griff mit einem in Richtung der Tür weisenden Aktivierungssensor und mit einem auf der der Tür abgewandten Seite des Griffes eingebauten Messsensor, in Draufsicht,
- Figur 2: den Griff gemäß Figur 1 entlang der Schnittlinie II -II und
- Figur 3: einen schematischen Schaltkreis zur Abfrage und Betätigung einer Zugangsberechtigung und zur Betätigung des Türschlosses.

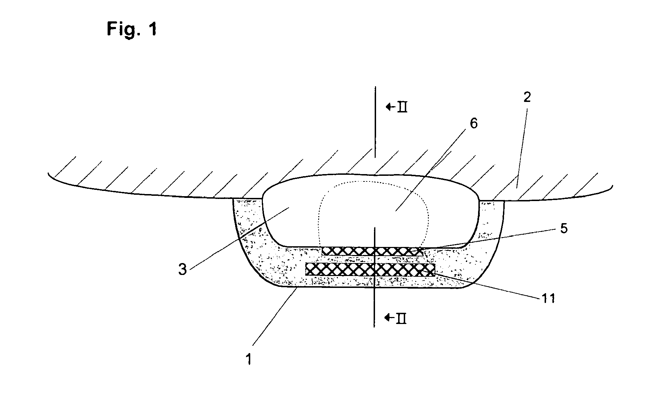

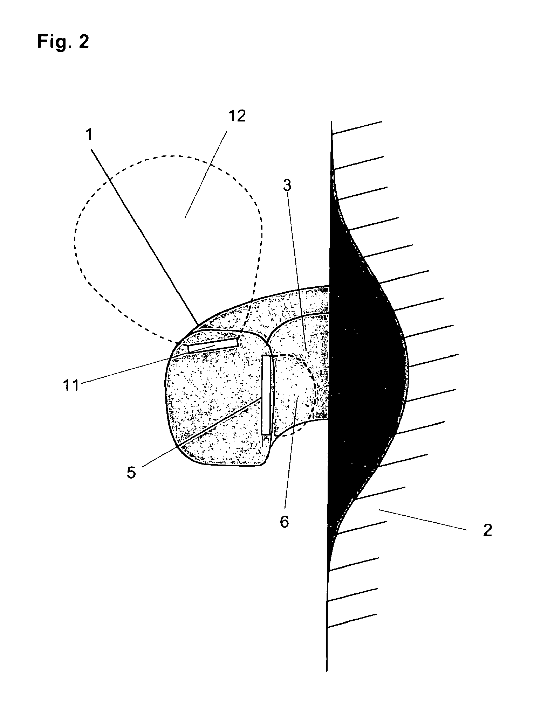

Den Figuren 1 und 2 ist die Anordnung eines Griffes 1 an einer Tür 2, insbesondere einer Fahrzeugtür, zu entnehmen. Der Griff 1 dient zum Öffnen und Schließen der Türe 2, wodurch zwischen dem Griff 1 und der Tür 2 ein Zwischenraum 3 vorgesehen ist, in den die Finger eines Benutzers eintauchen können, um ein Aktivierungsfeld 6 zu aktivieren.

Zur Aktivierung eines die Türe 2 zunächst verriegelnden Türschlosses 4 wird ein Aktivierungssensor 5 in den Griff 1 eingebaut, der in Richtung der Tür 2 weist und durch den das benötigte Aktivierungsfeld 6 erzeugt wird, das im wesentlichen im Bereich des Zwischenraumes 3 verläuft. Sobald nunmehr die Hand oder ein Finger eines Benutzers in den Zwischenraum 3 eintaucht, wird das Aktivierungsfeld 6 verändert. Diese Feldveränderung wird vom Aktivierungssensor 5 gemessen.

Des Weiteren ist im oberen und vorderen Bereich des Griffes 1 ein Messsensor 11 eingebaut, durch den ein von der Tür 2, wie dies insbesondere der Figur 2 entnommen werden kann, räumliches Messfeld 12 generiert wird. Das Messfeld 12 soll in dem Bereich verlaufen, in dem die Hand des Benutzers in Richtung des Griffes 1 bewegt wird. Taucht in das Messfeld 12 ein Gegenstand ein, verändert sich das Messfeld. Eine solche Veränderung des Messfelds 12 wird vom Messsensor 11 registriert und in entsprechende elektrische Signale umgewandelt.

Sowohl die Bewegungsrichtung als auch die Bewegungsgeschwindigkeit verändern das Messfeld 12 derart, dass diese von dem Messsensor 11 erfassbar sind. Die gewonnenen Messdaten werden mit charakteristischen Annäherungsdaten einer Handbewegung verglichen, wodurch exakt feststellbar ist, ob die erfasste Bewegung eines Objektes mit der Handannäherung übereinstimmt.

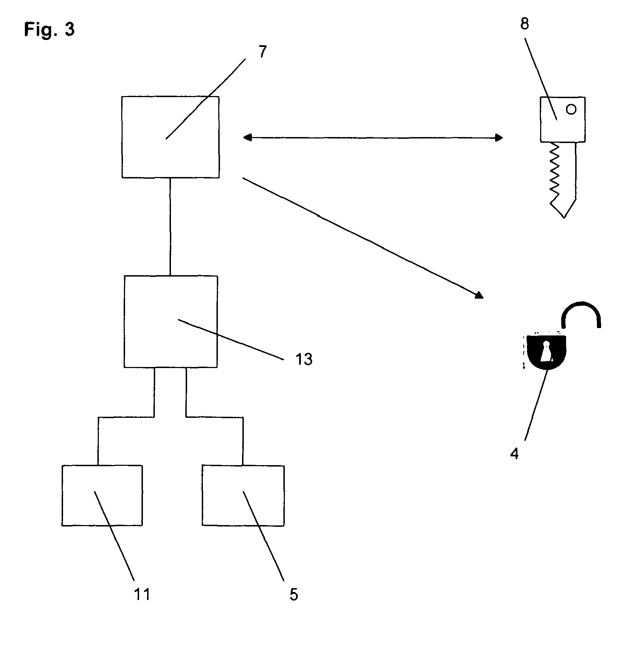

Aus der Figur 3 ist ersichtlich, in welcher elektrischen Weise die einzelnen Bauteile zusammengeschaltet sind, um das Öffnen und Schließen der Türe 2 sowie die Abfrage der Zugangsberechtigung für das Entriegeln der Türe 2 zu starten. Der im äußeren Bereich des Griffes 1 eingebaute Messsensor 11 ist als kapazitiver Messsensor 11 ausgebildet und erzeugt demnach ein kapazitives Messfeld 12. Wenn nunmehr ein Objekt in das kapazitive Messfeld 12 eintaucht, verändert sich der kapazitive Wert des Messfeldes 12. Dies wird vom Messsensor 11 gemessen und in ein elektrisches Signal umgewandelt. Der Messsensor 11 ist mit einer Auswerteeinheit 13 elektrisch verbunden, durch die das elektrische Schaltsignal weiterverarbeitet wird. Insbesondere kann durch die Auswerteeinheit 13 ermittelt werden, ob das Objekt mit einer bestimmten Geschwindigkeit in Richtung auf den Messsensor 11 bewegt wird.

Sobald durch die Auswerteeinheit 13 festgestellt wurde, dass tatsächlich ein Benutzer in Richtung der Tür 2 seine Hand ausstreckt, wird eine mit der Auswerteeinheit 13 elektrisch verbundenes Steuergerät 7 aktiviert, durch das eine Abfrage gestartet wird, um die Zugangsberechtigung eines elektronischen Schlüssels 8 des auf das Fahrzeug herangetretenen Benutzers zu ermitteln. Wird durch das Steuergerät 7 die Zugangsberechtigung festgestellt, wird das Schloss 4 der Tür 2 geöffnet.

Sobald durch den Aktivierungssensor 5 festgestellt wurde, dass die Hand des Benutzers in den Zwischenraum 3 eingetaucht ist, erhält die Auswerteinheit 13 ein entsprechendes Freigabesignal, so dass durch dieses das Steuergerät 7, das mit dem Türschloss 4 der Tür 2 elektrisch in Verbindung steht, geöffnet wird. Es ist denkbar, nunmehr durch die manuelle Betätigung des Griffes 1 die Tür 2 zu öffnen oder aber es sind elektrische, hydraulische oder pneumatische Öffnungs- bzw. Schließeinrichtungen der Tür 2 zugeordnet, durch die diese auch automatisch selbsttätig geöffnet bzw. geschlossen wird, wenn der Benutzer den Griff 1 umschließt und damit den Aktivierungssensor 5 in entsprechender Weise aktiviert hat.

Die in den Griff eingebaute Sensorik bestehend aus einem Messsensor 11 kann auch in einem Bedienfeld für eine Maschine, an einer Gebäudefassade oder dergleichen angeordnet sein.

Wenn mehrere der Messsensoren 11 unmittelbar benachbart zueinander an solchen Trägerbarteilen angebracht sind und jeder der Messsensoren 11 ein eigenständiges Messfeld 12 generiert, können die kapazitiven Veränderungen des Messfeldes 12 von der Auswerteinheit 13 dazu verwendet werden, die Bewegungseinrichtung der sich annährenden Objektes festzustellen.

## Patentansprüche

1. Kapazitiver Messsensor (11) zur Erkennung der Annäherung eines Objektes (9) in Richtung des Messsensors (11), durch den ein kapazitives Messfeld (12) generierbar und durch den das Eindringen des Objektes (9) in das Messfeld (12) feststellbar ist,
**dadurch gekennzeichnet,**
**dass** mehrere der Messsensoren (11) in einem Bauteil (1') integriert sind, dass durch die Messsensoren (11) jeweils eines der Messfelder (12) erzeugbar ist, die in eine vorgegebene Richtung weisen und die elektrisch voneinander getrennt sind, und dass durch die Veränderung der Messfelder (12) elektrische Signale erzeugbar sind, durch die die charakteristische Annäherung des sich auf die Messsensoren (11) zu bewegenden Objektes (9) bestimmbar ist.

2. Messsensor nach Anspruch 1,
**dadurch gekennzeichnet,**
**dass** durch die Positionierung und Ausrichtung der eingesetzten Messsensoren (11) die charakteristische Annäherung des Objektes (9) in Form der geometrischen Abmessung, der Bewegungsrichtung und der
Bewegungsgeschwindigkeit messbar ist.

3. Messsensor nach Anspruch 1 oder 2,
**dadurch gekennzeichnet,**
**dass** die Messsensoren (11) mit einer elektrisch betriebenen Auswerteeinheit (13) verbunden sind, durch die die von den Messsensoren (11) gemessenen Veränderungen des jeweiligen Messfeldes (12) auswertbar und weiterverarbeitbar sind.

4. Messsensor nach Anspruch 3,
**dadurch gekennzeichnet,**
**dass** die Auswerteeinheit (13) mit einem Steuergerät (7) elektrisch gekoppelt ist und dass das Steuergerät (7) durch die Auswerteeinheit (13) aktivierbar ist.

5. Sensor nach Anspruch 1,
**dadurch gekennzeichnet,**
**dass** die von zwei benachbarten Messsensoren (11) generierten Messfelder (12) in einem vorgegebenen Winkel, vorzugsweise senkrecht, zueinander verlaufen.

6. Griff (1), insbesondere zum automatischen Öffnen oder Schließen einer Tür (2), mit einem in den Griff (1) eingebauten und der Tür (2) zugeordneten Aktivierungssensor (5) und mit einem Steuergerät (7), das elektrisch mit dem Aktivierungssensor (5) verbunden ist,
**dadurch gekennzeichnet,**
**dass** in dem Griff (1) mindestens ein Messsensor (11) angeordnet ist, durch den jeweils ein sich räumlich von der Tür (2) ausdehnendes Messfeld (12) erzeugbar ist, und dass durch das Messfeld (12) ein eintauchendes Objekt derart erfassbar ist, dass die geometrische Abmessung und/oder die Bewegungs- und / oder Geschwindigkeitscharakteristik des Objektes mittels des Messsensors (11) durch die eintretenden Veränderungen des Messfeldes (12) erkennbar und auswertbar sind.

7. Griff nach Anspruch 6,
**dadurch gekennzeichnet,**
**dass** das Messfeld (12) in Bewegungsrichtung des sich dem Griff (1) annähernden Objektes zu dessen Betätigung ausgerichtet ist und dass durch den Messsensor (11) die charakteristischen Bewegungsmerkmale des in das Messfeld (12) eingetauchten Objektes in elektrische Signale umwandelbar sind, die an das Steuergerät (7) in Form von elektrischen Aktivierungssignalen übertragbar sind.

8. Griff nach Anspruch 6 oder 7,
**dadurch gekennzeichnet,**
**dass** die Aktivierungs- und/ oder Messsensoren (3; 11) jeweils als kapazitive Näherungssensoren ausgebildet sind, durch die jeweils ein kapazitives Aktivierungs- und Messfeld (6, 12) erzeugbar ist, dessen Kapazitäten in Abhängigkeit von einem in das Feld eindringenden Objektes veränderbar und messbar sind.
